# FASCICULE DE BREVET EUROPEEN

(11) **EP 2 362 720 B1**
(45) Date de publication et mention de la délivrance du brevet: **18.10.2017**
(21) Numéro de dépôt: 11155065.3
(22) Date de dépôt: 18.02.2011
(51) Int. Cl.: H05K 7/14

(54) **Module électronique et ensemble électronique comportant un tel module**
Elektronisches module und elektronische Anordnung umfassend dieses Modul
Electronic module and electronique assembly comprising the same

(30) Priorité: 18.02.2010 FR 1051184
(43) Date de publication de la demande: 31.08.2011
(73) Titulaire: Airbus Operations, 31060 Toulouse (FR)
(72) Inventeur: Colongo, Emile, 31310, Montesquieu Volvestre (FR); Roujean, Olivier, 31200, Toulouse (FR)
(74) Mandataire: Santarelli

(56) Documents cités:
- EP-A1- 1 947 921
- WO-A1-01/49092
- GB-A- 2 145 290
- US-A1- 2008 019 102

## Description

La présente invention concerne des modules électroniques, formés d'une carte électronique protégée par deux capots.

Ces modules électroniques sont manipulés pour être connectés dans un ensemble électronique embarqué, à titre d'exemple dans l'aviation. La carte électronique porte des moyens de connexion aptes à coopérer avec l'ensemble électronique embarqué, et les capots protègent les composants électroniques implantés sur la carte contre les chocs survenant lors de la manutention.

Le document EP 1 947 921 divulgue un tel module électronique. Les capots inférieur et supérieur sont fixés l'un à l'autre par des vis, et la carte électronique est maintenue entre ces capots. La chaleur générée par les composants électroniques s'évacue à l'air libre par l'intermédiaire des capots, et par la présence éventuelle d'un dissipateur thermique rapporté ou intégré sur l'un des capots. Le document "US 2008/019102" décrit un appareil modulaire selon le préambule de la revendication 1. Toutefois, l'évolution des technologies dans le domaine électronique tend à augmenter les densités de puissance dissipées dans les composants électroniques, et la chaleur à évacuer est donc de plus en plus forte.

L'invention vise à proposer un module électronique apte à évacuer une quantité de chaleur plus importante que dans l'art antérieur et dont l'assemblage est amélioré. Un tel module est notamment utilisé dans un ensemble électronique avec un boîtier de connexion dans lequel des zones de glissière sont prévues pour permettre le montage des modules électroniques.

A cet effet, l'invention a pour objet un module électronique, comportant une carte électronique, sensiblement plane, sur une première face sur laquelle sont disposés des composants électroniques, un premier et un deuxième capots, disposés de part et d'autre de la carte électronique, et dans lequel le premier capot, qui est en regard de la première face de la carte électronique, présente une partie centrale, qui s'étend à distance de la première face de la carte électronique, et au moins un bord tombé, orienté vers la carte électronique et prolongeant un deux côtés opposés de la partie centrale, caractérisé en ce que ledit au moins un bord tombé du premier capot est prolongé par un appui sensiblement plan, s'étendant dans un plan parallèle au plan de la carte électronique, la carte électronique étant rapportée sur ledit appui du premier capot.

Un tel module permet avantageusement de drainer les calories vers l'appui du ou des capots, et de diriger par la suite la chaleur à évacuer des composants thermiques vers des zones froides formées par exemple par des zones de glissière, avec lesquelles l'appui du ou des capots est apte à coopérer.

Au moins un des capots porte des premiers moyens d'indexage et la carte électronique présente des seconds moyens d'indexage complémentaires aptes à coopérer avec les premiers moyens d'indexage lors de la mise en position de la carte électronique entre les capots.

Ces moyens d'indexage permettent d'améliorer simplement le positionnement de la carte électronique par rapport à au moins un capot lors de l'assemblage du module. Ainsi l'assemblage est facilité et donc plus rapide à effectuer. On notera que les deux capots peuvent porter des moyens d'indexage coopérant chacun avec des moyens d'indexage complémentaires de la carte.

Selon une caractéristique possible, le premier capot présente deux bords tombés orientés vers la carte électronique et prolongeant les deux côtés opposés de la partie centrale.

Les bords tombés sont prolongés chacun par un appui sensiblement plan s'étendant dans un plan parallèle au plan de la carte électronique, celle-ci étant rapportée sur les appuis du premier capot.

Selon différentes caractéristiques possibles de l'invention, prises individuellement ou en combinaison :
- les premiers ou les seconds moyens d'indexage sont des trous, tandis que respectivement les seconds ou les premiers moyens d'indexage sont des éléments saillants qui sont aptes à s'engager dans les trous ; ainsi l'un ou l'autre parmi la carte et un capot peut porter les premiers ou les seconds moyens d'indexage ;
- le deuxième capot présente une forme sensiblement correspondante à la forme du premier capot, avec une partie centrale et au moins un appui qui est en contact avec la deuxième face de la carte électronique ;
- au moins un point de contact thermique est réalisé entre un capot et l'un des composants électroniques de la carte électronique ;
- une interface thermique est disposée entre l'un des composants électroniques et au moins un capot ;
- le premier capot présente sur sa face opposée à la carte électronique un dissipateur thermique venu de matière avec le premier capot ; et/ou
- la surface de contact entre la carte électronique et au moins un appui du premier capot s'étend de façon continue, sur sensiblement toute la longueur de la carte.

En outre, l'invention a également pour objet un ensemble électronique, comportant au moins un module électronique, formé d'une carte électronique, d'un premier et d'un deuxième capots, et un boîtier de connexion dans lequel des zones de glissière sont disposées pour permettre le montage d'au moins un module électronique dans ledit boîtier, caractérisé en ce que le premier capot présente au moins un appui sur lequel est rapportée la carte électronique, ledit au moins un appui du premier capot étant au contact d'une paroi de la zone de glissière correspondante, lorsque le module électronique est monté dans le boîtier de connexion, au moins un des capots portant des premiers moyens d'indexage, la carte électronique présentant des seconds moyens d'indexage complémentaires aptes à coopérer avec les premiers moyens d'indexage lors de la mise en position de la carte électronique entre les capots.

Selon différentes caractéristiques prises individuellement ou en combinaison :
- les premiers ou les seconds moyens d'indexage sont des trous, tandis que respectivement les seconds ou les premiers moyens d'indexage sont des éléments saillants qui sont aptes à s'engager dans les trous ;
- la carte électronique présente une première face sur laquelle sont disposés des composants électroniques, une première face dudit au moins un appui du premier capot étant au contact, d'une part, avec la paroi de la zone de glissière correspondante et, d'autre part, avec la première face de la carte électronique ;
- un moyen d'expansion est disposé dans les zones de glissière, de sorte que l'actionnement du moyen d'expansion est apte à presser au moins un appui du premier capot contre la paroi de la zone de glissière correspondante ;
- la carte électronique et les deux capots s'étendent sensiblement sur la même hauteur, de sorte que l'ensemble formé par la carte et les capots est disposé dans les zones de glissière, le premier capot étant au contact de la paroi des zones de glissière, la carte et le deuxième capot étant pressés contre le premier capot sous l'action du moyen d'expansion ;
- la première face de la carte électronique, en contact avec la première face dudit au moins un appui du premier capot, porte les premiers moyens de connexion.

L'invention a en outre pour objet un aéronef comportant au moins un module électronique ou un ensemble électronique tel que brièvement exposé ci-dessus.

D'autres particularités et avantages de l'invention apparaîtront au travers de la description faite en regard des figures annexées dans lesquelles :
- la figure 1 est une vue en éclaté, de trois quart avant, d'un module électronique selon un mode de réalisation de la présente invention ;
- la figure 2 est une vue de trois quart avant des moyens d'indexage de la carte sur un capot selon l'invention ;
- la figure 3 est une vue en perspective du boîtier de connexion dans lequel un module électronique est apte à être inséré ;
- la figure 4 est une vue en coupe, de trois quart avant, d'un ensemble électronique selon un premier mode de réalisation ;
- la figure 5 est une vue, dans une coupe similaire à celle de la figure 4, d'un ensemble électronique selon un deuxième mode de réalisation ; et
- la figure 6 est une vue de trois quart avant d'un ensemble électronique comportant le module électronique représenté à la figure 1.

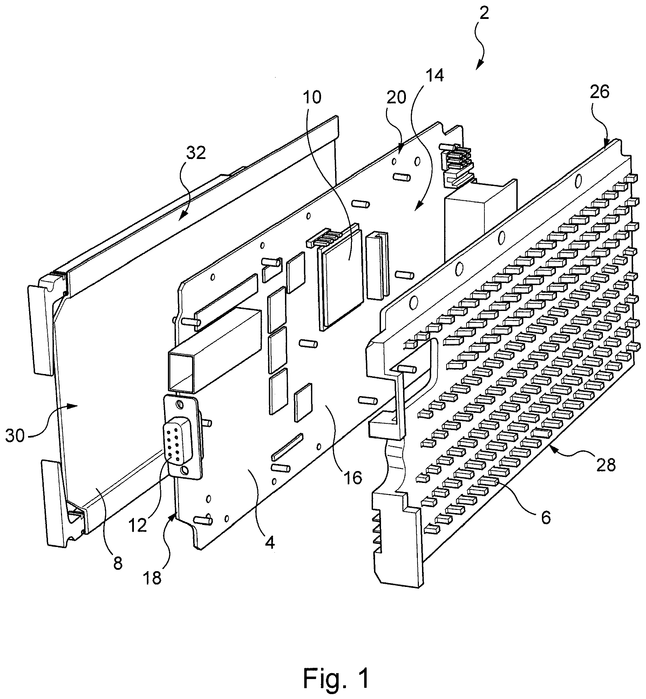

Comme représenté à la figure 1, un module électronique 2 comprend une carte électronique 4 et deux capots 6, 8 disposés de part et d'autre de la carte 4, de façon à recouvrir l'intégralité de ladite carte.

La carte électronique 4 est formée d'un circuit imprimé, sensiblement plan, sur lequel sont soudés des composants électroniques 10 et des premiers moyens de connexion 12 aptes à coopérer avec des seconds moyens de connexion, non représentés, d'un ensemble électronique embarqué. A titre d'exemple, un tel ensemble électronique embarqué et un module électronique associé peuvent être disposés dans un aéronef, ou dans tout autre moyen de transport dont le fonctionnement nécessite une électronique fournie. Cet ensemble électronique pourrait également être utilisé dans le domaine informatique.

La carte 4 présente une forme rectangulaire, avec une partie centrale 14, et les composants électroniques 10 ainsi que les premiers moyens de connexion 12 sont soudés dans cette partie centrale 14, sur la première face 16 de la carte. Plus particulièrement, les moyens de connexion 12 sont rapportés soudés sur un premier bord 18 de la partie centrale 14.

Les deux bords de la partie centrale 14 directement adjacents à ce premier bord 18 sont prolongés chacun par une zone d'appui 20, libre de composants électroniques, et qui s'étend suivant sensiblement la totalité de la longueur de la carte.

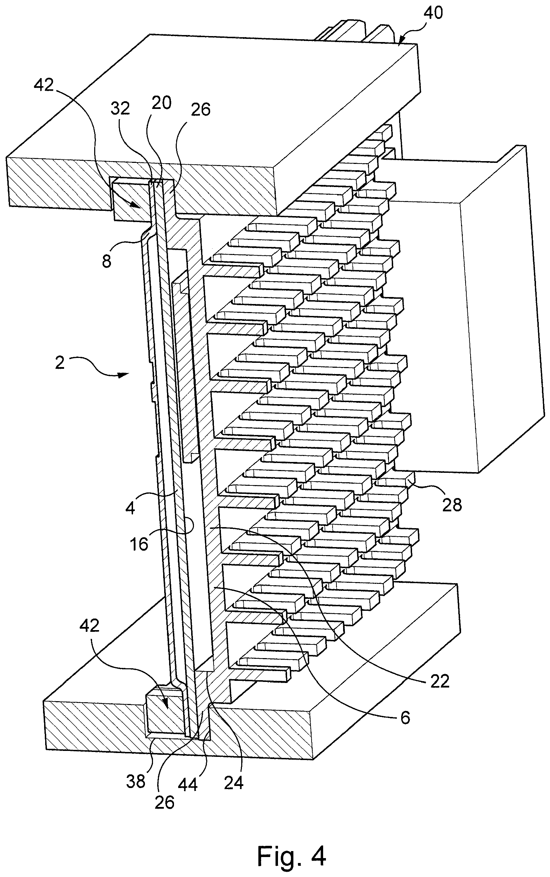

La carte électronique 4 est disposée entre le premier 6 et le deuxième 8 capots. Le premier capot 6 est l'élément de protection qui recouvre la première face 16 de la carte électronique 4, sur laquelle sont rapportés les composants électroniques 10. Le premier capot 6 présente une forme sensiblement en U, avec une partie centrale 22 et des bords tombés 24, tel que représenté notamment sur la figure 4.

La partie centrale 22 du premier capot 6 s'étend à distance de la première face 16 de la carte électronique 4, en vis à vis de la partie centrale 14 de ladite carte. Les deux bords tombés 24 prolongent deux côtés opposés de la partie centrale 22 du premier capot 6, et sont orientés vers la carte électronique 4.

Les bords tombés 24 du premier capot 6 sont prolongés par des appuis 26 sensiblement plans, qui s'étendent dans un plan parallèle au plan de la carte électronique 4, en s'éloignant l'un de l'autre à partir des bords tombés 24.

Le premier capot 6 présente sur sa face opposée à la carte électronique 4 un dissipateur thermique 28 venu de matière avec le premier capot.

On notera que tout autre dissipateur thermique peut être utilisé et, par exemple, plusieurs ailettes parallèles entre elles et agencées perpendiculairement à la face opposée du capot.

Le deuxième capot 8 présente une forme sensiblement équivalente à la forme du premier capot 6, avec une partie centrale 30 et des appuis 32, la partie centrale 30 étant en retrait par rapport au plan dans lequel s'étend la carte électronique 4. La partie centrale 30 est plane et propose une surface d'échange thermique avantageuse pour le refroidissement des composants situés en vis-à-vis.

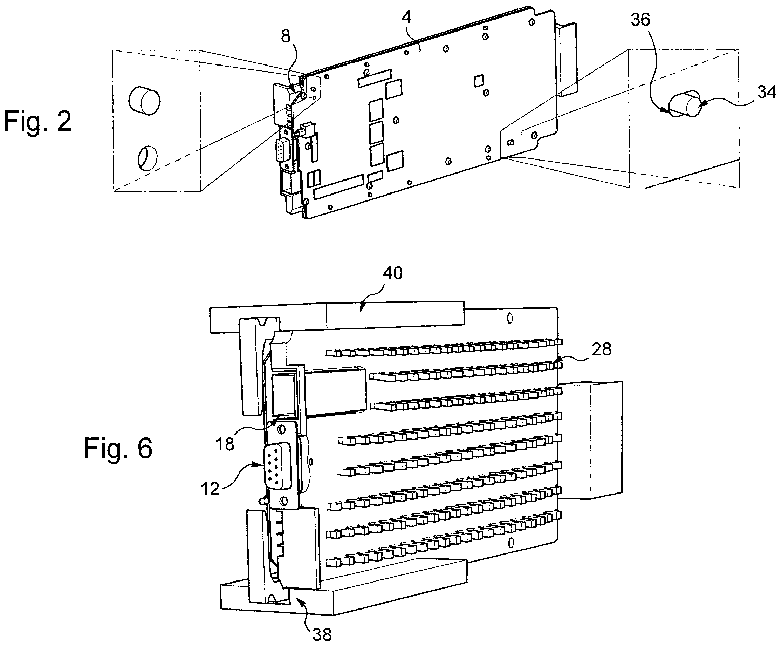

Des moyens d'indexage 34 (premiers moyens), représentés sur la figure 2, sont intégrés sur le deuxième capot 8, et présentent une forme et des dimensions qui les rendent aptes à coopérer avec d'autres moyens d'indexage de la carte (seconds moyens complémentaires), agencés en correspondance, par exemple des trous d'indexage 36 disposés sur la carte électronique 4, par engagement à l'intérieur de ceux-ci. On notera que les trous dans la carte ne sont pas nécessairement débouchants. Il peut ainsi par exemple juste s'agir d'évidements ou de cavités destinés à recevoir et à positionner les premiers moyens d'indexage du capot. Ces premiers et seconds moyens d'indexage, qui forment une pluralité de moyens d'indexage généralement répartis à plusieurs endroits du capot et de la carte, permettent de parfaire le positionnement de la carte électronique 4 par rapport à au moins un des éléments de capot 6, 8 lors de l'assemblage du module 2. Comme représenté sur la Figure 2, les premiers moyens d'indexage sont des éléments saillants s'étendant perpendiculairement à la face de la partie centrale 30 en regard de la carte 4. Plus particulièrement, les éléments saillants sont des pions ou doigts qui sont par exemple issus de fabrication lors de la fabrication du capot. On notera que les moyens 34 peuvent alternativement être portés par la carte, tandis que les moyens 36 sont portés par le capot 6. Par ailleurs, le capot 8 peut alternativement porter des moyens d'indexage coopérant avec des moyens d'indexage complémentaires de la carte.

Selon une variante non représentée, on notera que les deux capots et la carte peuvent porter chacun des moyens d'indexage afin de faciliter le positionnement de la carte par rapport à chaque capot. Par exemple, le capot 6 comporte des premiers moyens d'indexage identiques aux moyens 34 et qui sont adaptés à coopérer avec des moyens d'indexage complémentaires de la carte, identiques aux moyens 36 mais localisés à un autre endroit.

Selon une autre variante non représentée, les premiers et seconds moyens d'indexage peuvent revêtir d'autres formes et, par exemple, être du type tenon-mortaise.

Comme évoqué précédemment, l'assemblage de la carte 4 et des capots 6, 8 forme le module électronique 2.

La carte électronique 4 est disposée entre les capots 6 et 8, de sorte que les parties centrales des capots et de la carte se superposent. Dans cet agencement, les zones d'appui 20 de la carte électronique 4 sont serrées entre les appuis 26, 32 des capots respectifs 6, 8, qui s'étendent sur sensiblement toute la longueur de ladite carte électronique.

Les composants électroniques 10 sont disposés dans le volume créé par la forme en U du premier capot 6, et sont ainsi protégés contre les chocs éventuels lors d'une manutention. Les premiers moyens de connexion 12, rapportés sur le premier bord 18 de la première face 16 de la carte, peuvent également être au moins en partie recouverts et protégés par le premier capot 6.

La zone de contact créée entre la carte électronique et les capots, au niveau des appuis, permet un drainage thermique optimal vers l'appui 26 du premier capot 6, dans le but de dissiper les calories drainées vers une zone froide, décrite par la suite, et dans l'air ambiant par le dissipateur thermique 28.

Ces zones de contacts, réalisées sur deux côtés opposés des parties centrales, confèrent en outre une rigidité à l'ensemble et une planéité améliorée de la carte électronique.

Des contacts thermiques peuvent être avantageusement conçus entre les composants électroniques 10 et l'un des éléments de capot 6, 8, afin de drainer dans les capots une grande partie de la puissance dissipée par la carte, et notamment pour les composants dégageant le plus de calories. Dans un mode de réalisation non représenté, ce contact thermique peut être optimisé en intercalant une interface thermique diminuant la résistance thermique du contact.

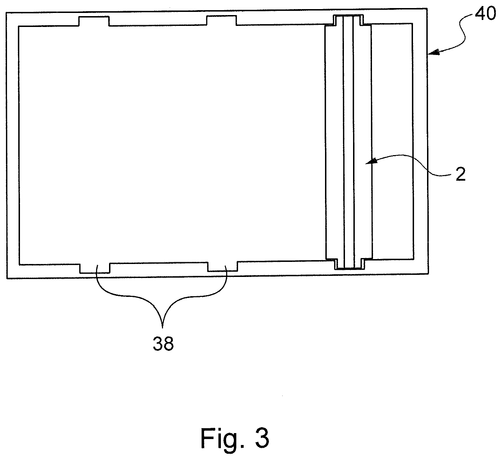

En référence aux figures 3 à 6, on décrit maintenant un ensemble électronique selon l'invention, dans lequel un module électronique 2, formé d'une carte 4 et de deux éléments de capot 6, 8, est apte à coopérer avec des zones de glissière 38 disposées dans un boîtier de connexion 40. Pour des raisons de commodité, seule la coopération entre les appuis supérieurs du module et la zone de glissière supérieure du boîtier de connexion va être décrite.

Il sera compris qu'avantageusement deux zones de glissière sont prévues pour que le déplacement du module 2 soit facilité. A titre d'exemple, notamment représenté figure 3, ces zones de glissière 38 sont formées sur un boîtier de connexion 40. Le boîtier présente des zones de glissière hautes et basses, permettant d'insérer les modules électroniques. Des glissières 38 sont formées dans deux faces opposées du boîtier de connexion 40, afin de constituer des paires de glissières en vis-à-vis destinées à recevoir des modules électroniques 2.

Selon un premier mode de réalisation, représenté à la figure 4, la zone d'appui 20 de la carte électronique 4 est pincée entre l'appui 26 du premier capot 6 et l'appui 32 du deuxième capot 8. La carte électronique 4 et les deux capots s'étendent sensiblement sur la même hauteur, de sorte que l'ensemble formé par la carte 4 et les capots 6, 8 est disposé dans les zones de glissière 38 et coulisse dans ces glissières jusqu'à la mise en place effective. Un mécanisme d'expansion 42 permet de combler le jeu fonctionnel de glissement entre la zone de glissière 38 et le module électronique 2, et permet de pincer la zone d'appui 20 de la carte électronique 4 entre l'appui 26 du premier capot 6, et l'appui 32 du deuxième capot 8. A titre d'exemple, le mécanisme d'expansion 42 est une came dont la mise en rotation permet de presser l'ensemble du module 2 contre une paroi de la zone de glissière 38.

Le contact entre le module 2 et la glissière 38 se fait par l'intermédiaire d'une face de l'appui 26 du premier capot 6 et d'une paroi 44 de la zone de glissière 38.

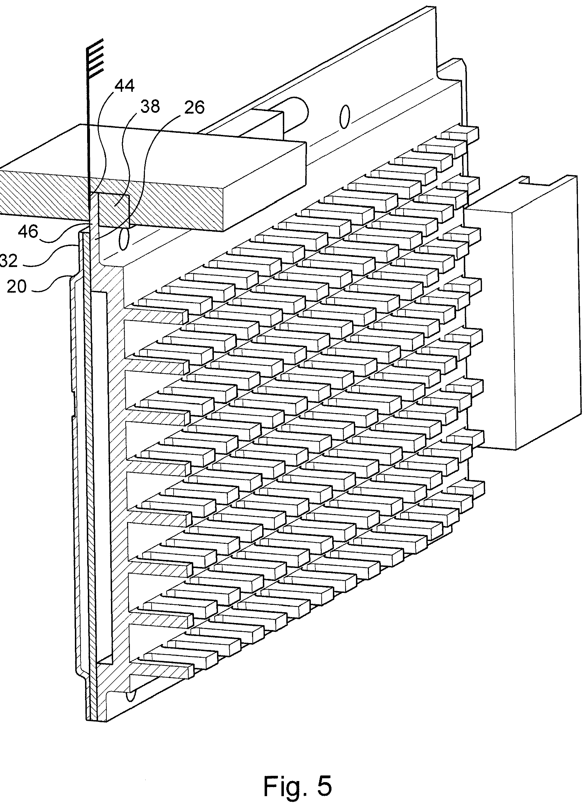

Selon un deuxième mode de réalisation, représenté à la figure 5, seule l'appui 26 du premier capot 6 est situé dans la zone de glissière 38. La partie supérieure de cet appui 26 du premier capot est au contact d'une paroi 44 de la zone de glissière 38, plaquée contre celle-ci par l'intermédiaire d'un moyen d'expansion 42. La zone d'appui 20 de la carte électronique 4 et l'appui 32 du deuxième capot 8, qui sont moins étendus que l'appui 26 du premier capot, sont rapportés vissés sur une partie inférieure de l'appui 26 du premier capot 6, la zone d'appui 20 de la carte électronique 4 étant disposée entre la partie inférieure de l'appui 26 du premier capot 6 et l'appui 32 du deuxième capot 8.

Dans les deux modes de réalisation représentés figures 4 et 5, l'ensemble électronique présente l'avantage de pouvoir drainer les calories reçues par le premier capot 6 vers une zone froide formée par la zone de glissière 38 dans le boîtier de connexion 40. Le contact de l'appui 26 du premier capot 6 avec la paroi 44 de cette glissière 38 offre ainsi un chemin de dissipation thermique supplémentaire, en plus du dissipateur thermique 28 disposé au dos du premier capot 6.

En outre, dans le cas de la figure 5, où seul l'appui 26 du premier capot 6 est situé dans la zone de glissière 38, une première face 46 de l'appui 26 est au contact avec la paroi 44 de la glissière 38 correspondante, et c'est cette première face 46 de l'appui 26 qui est également en contact avec la première face 16 de la carte électronique 4 portant les moyens de connexion.

Il en résulte un positionnement plus précis des moyens de connexion 12 du module 2 par rapport au boîtier de connexion 40, et donc un positionnement plus précis par rapport aux seconds moyens de connexion non représentés, portés à titre d'exemple par le fond du boîtier de connexion 40.

## Revendications

1. Module électronique (2), comportant
- une carte électronique (4), sensiblement plane, sur une première face (16) de laquelle sont disposés des composants électroniques (10),
- un premier (6) et un deuxième (8) capots, disposés de part et d'autre de la carte électronique (4),
et dans lequel le premier capot (6), qui est en regard de la première face (16) de la carte électronique (4), présente une partie centrale (22), qui s'étend à distance de la première face (16) de la carte électronique (4), et au moins un bord tombé (24) orienté vers la carte électronique (4) et prolongeant un des deux côtés opposés de la partie centrale (22),
**caractérisé en ce que** ledit au moins un bord tombé (24) du premier capot (6) est prolongé par un appui (26) sensiblement plan, s'étendant dans un plan parallèle au plan de la carte électronique (4), la carte électronique (4) étant rapportée sur ledit appui (26) du premier capot (6), au moins un des capots (6, 8) portant des premiers moyens d'indexage (34), la carte électronique (4) présentant des seconds moyens d'indexage complémentaires (36) aptes à coopérer avec les premiers moyens d'indexage (34) lors de la mise en position de la carte électronique (4) entre les capots (6, 8).

2. Module électronique selon la revendication 1, **caractérisé en ce que** les premiers ou les seconds moyens d'indexage sont des trous, tandis que respectivement les seconds ou les premiers moyens d'indexage sont des éléments saillants qui sont aptes à s'engager dans les trous.

3. Module électronique selon la revendication 1 ou 2, **caractérisé en ce que** le deuxième capot (8) présente une forme sensiblement correspondante à la forme du premier capot (6), avec une partie centrale (30) et au moins un appui qui est en contact avec la deuxième face de la carte électronique (4).

4. Module électronique selon l'une des revendications 1 à 3, **caractérisé en ce qu'**au moins un point de contact thermique est réalisé entre un capot (6, 8) et l'un des composants électroniques (14) de la carte électronique (4).

5. Module électronique selon la revendication 4, **caractérisé en ce qu'**une interface thermique est disposée entre l'un des composants électroniques (10) et au moins un capot (6, 8).

6. Ensemble électronique, comportant au moins un module électronique selon l'une des revendications 1 à 5, formé d'une carte électronique (4), d'un premier (6) et d'un deuxième (8) capots, et un boîtier de connexion (40) dans lequel des zones de glissière (38) sont disposées pour permettre le montage d'au moins un module électronique (2) dans ledit boîtier (40), **caractérisé en ce que** le premier capot (6) présente au moins un appui (26) sur lequel est rapportée la carte électronique (4), ledit au moins un appui (26) du premier capot (6) étant au contact d'une paroi (44) de la zone de glissière correspondante, lorsque le module électronique (2) est monté dans le boîtier de connexion (40), au moins un des capots (6, 8) portant des premiers moyens d'indexage (34), la carte électronique (4) présentant des seconds moyens d'indexage (36) complémentaires aptes à coopérer avec les premiers moyens d'indexage (34) lors de la mise en position de la carte électronique (4) entre les capots (6, 8).

7. Ensemble électronique selon la revendication 6, **caractérisé en ce que** les premiers ou les seconds moyens d'indexage sont des trous, tandis que respectivement les seconds ou les premiers moyens d'indexage sont des éléments saillants qui sont aptes à s'engager dans les trous.

8. Ensemble électronique selon la revendication 6 ou 7, **caractérisé en ce que** la carte électronique (4) présente une première face (16) sur laquelle sont disposés des composants électroniques (10), une première face (46) dudit au moins un appui (26) du premier capot (6) étant au contact, d'une part, avec la paroi (44) de la zone de glissière correspondante, et, d'autre part, avec la première face (16) de la carte électronique (4).

9. Ensemble électronique selon l'une des revendications 6 à 8, **caractérisé en ce qu'**un moyen d'expansion (42) est disposé dans les zones de glissière (38), de sorte que l'actionnement du moyen d'expansion (42) est apte à presser au moins un appui (26) du premier capot (6) contre la paroi (44) de la zone de glissière correspondante (38).

10. Ensemble électronique selon la revendication 9, **caractérisé en ce que** la carte électronique (4) et les deux capots (6, 8) s'étendent sensiblement sur la même hauteur, de sorte que l'ensemble formé par la carte (4) et les capots (6, 8) est disposé dans les zones de glissière (38), le premier capot (6) étant au contact de la paroi (44) des zones de glissière (38), la carte (4) et le deuxième capot (8) étant pressés contre le premier capot (6) sous l'action du moyen d'expansion (42).

11. Aéronef **caractérisé en ce qu'**il comporte au moins un module électronique selon l'une des revendications 1 à 5 ou au moins un ensemble électronique selon l'une des revendications 6 à 10.

## Patentansprüche

1. Elektronisches Modul (2), umfassend
- eine im Wesentlichen flache Elektronikkarte (4), bei der auf einer ersten Seite (16) Elektronikkomponenten (10) angeordnet sind,
- eine erste (6) und eine zweite (8) Kappe, die beiderseits der Elektronikkarte (4) angeordnet sind,
und bei dem die erste Kappe (6), die der ersten Seite (16) der Elektronikkarte (4) gegenüberliegt, einen zentralen Teil (22), der sich in einem Abstand zu der ersten Seite (16) der Elektronikkarte (4) erstreckt, und mindestens einen Randflansch (24) aufweist, der zu der Elektronikkarte (4) gerichtet ist und eine der zwei gegenüberliegenden Seiten des zentralen Teils (22) verlängert,
**dadurch gekennzeichnet, dass** der mindestens eine Randflansch (24) der ersten Kappe (6) durch eine im Wesentlichen flache Abstützung (26) verlängert ist, die sich in einer Ebene parallel zur Ebene der Elektronikkarte (4) erstreckt, wobei die Elektronikkarte (4) auf die Abstützung (26) der ersten Kappe (6) aufgesetzt ist, wobei mindestens eine der Kappen (6, 8) erste Indexierungsmittel (34) trägt, wobei die Elektronikkarte (4) zweite komplementäre Indexierungsmittel (36) aufweist, die geeignet sind, mit den ersten Indexierungsmitteln (34) bei der Positionierung der Elektronikkarte (4) zwischen den Kappen (6, 8) zusammenzuwirken.

2. Elektronisches Modul nach Anspruch 1, **dadurch gekennzeichnet, dass** die ersten oder die zweiten Indexierungsmittel Löcher sind, während die zweiten bzw. die ersten Indexierungsmittel vorspringende Elemente sind, die geeignet sind, in die Löcher einzugreifen.

3. Elektronisches Modul nach Anspruch 1 oder 2, **dadurch gekennzeichnet, dass** die zweite Kappe (8) eine Form im Wesentlichen entsprechend der Form der ersten Kappe (6) aufweist, mit einem zentralen Teil (30) und mindestens einer Abstützung, die mit der zweiten Seite der elektronischen Karte (4) in Kontakt ist.

4. Elektronisches Modul nach einem der Ansprüche 1 bis 3, **dadurch gekennzeichnet, dass** mindestens ein thermischer Kontaktpunkt zwischen einer Kappe (6, 8) und einer der elektronischen Komponenten (14) der elektronischen Karte (4) hergestellt ist.

5. Elektronisches Modul nach Anspruch 4, **dadurch gekennzeichnet, dass** eine thermische Schnittstelle zwischen einer der elektronischen Komponenten (10) und mindestens einer Kappe (6, 8) angeordnet ist.

6. Elektronische Einheit, umfassend mindestens ein elektronisches Modul nach einem der Ansprüche 1 bis 5, das von einer Elektronikkarte (4), einer ersten (6) und einer zweiten (8) Kappe und einem Anschlussgehäuse (40) gebildet ist, in dem Gleitzonen (38) angeordnet sind, um die Montage mindestens eines elektronischen Moduls (2) in dem Gehäuse (40) zu ermöglichen, **dadurch gekennzeichnet, dass** die erste Kappe (6) mindestens eine Abstützung (26) aufweist, auf die die Elektronikkarte (4) aufgesetzt ist, wobei die mindestens eine Abstützung (26) der ersten Kappe (6) mit einer Wand (44) der entsprechenden Gleitzone in Kontakt ist, wenn das elektronische Modul (2) in dem Anschlussgehäuse (40) montiert ist, wobei mindestens eine der Kappen (6, 8) erste Indexierungsmittel (34) trägt, wobei die Elektronikkarte (4) zweite komplementäre Indexierungsmittel (36) aufweist, die geeignet sind, mit den ersten Indexierungsmitteln (34) bei der Positionierung der Elektronikkarte (4) zwischen den Kappen (6, 8) zusammenzuwirken.

7. Elektronische Einheit nach Anspruch 6, **dadurch gekennzeichnet, dass** die ersten oder die zweiten Indexierungsmittel Löcher sind, während die zweiten bzw. die ersten Indexierungsmittel vorspringende Elemente sind, die geeignet sind, in die Löcher einzugreifen.

8. Elektronische Einheit nach Anspruch 6 oder 7, **dadurch gekennzeichnet, dass** die Elektronikkarte (4) eine erste Seite (16) aufweist, auf der Elektronikkomponenten (10) angeordnet sind, wobei eine erste Seite (46) der mindestens einen Abstützung (26) der ersten Kappe (6) einerseits mit der Wand (44) der entsprechenden Gleitzone und andererseits mit der ersten Seite (16) der Elektronikkarte (4) in Kontakt ist.

9. Elektronische Einheit nach einem der Ansprüche 6 bis 8, **dadurch gekennzeichnet, dass** ein Expansionsmittel (42) in den Gleitzonen (38) angeordnet ist, so dass die Betätigung des Expansionsmittels (42) geeignet ist, mindestens eine Abstützung (26) der ersten Kappe (6) gegen die Wand (44) der entsprechenden Gleitzone (38) zu drücken.

10. Elektronische Einheit nach Anspruch 9, **dadurch gekennzeichnet, dass** sich die Elektronikkarte (4) und die zwei Kappen (6, 8) im Wesentlichen auf derselben Höhe erstrecken, so dass die von der Karte (4) und den Kappen (6, 8) gebildete Einheit in den Gleitzonen (38) angeordnet ist, wobei die erste Kappe (6) mit der Wand (44) der Gleitzonen (38) in Kontakt ist, wobei die Karte (4) und die zweite Kappe (8) gegen die erste Kappe (6) unter der Wirkung des Expansionsmittels (42) gedrückt werden.

11. Flugzeug, **dadurch gekennzeichnet, dass** es mindestens ein elektronisches Modul nach einem der Ansprüche 1 bis 5 oder mindestens eine elektronische Einheit nach einem der Ansprüche 6 bis 10 umfasst.

## Claims

1. An electronic module (2), comprising:
- an electronic card (4), substantially flat, on a first face (16) of which electronic components (10) are disposed,
- a first cover (6) and a second cover (8), disposed on either side of the electronic card (4),
and in which the first cover (6), which is opposite the first face (16) of the electronic card (4), has a central part (22), which extends at a distance from the first face (16) of the electronic card (4), and at least one flanged edge (24) turned toward the electronic card (4) and prolonging one of the two opposite sides of central part (22),
**characterised in that** said at least one flanged edge (24) of the first cover (6) is a substantially flat support (26), extending in a plane parallel to the plane of the electronic card (4), the electronic card (4) being added onto the said support (26) of the first cover (6), at least one of the covers (6, 8) including first indexing elements (34) prolonged, the electronic card (4) including second complementary indexing elements (36) that can engage with the first indexing elements (34) during positioning of the electronic card (4) between the covers (6, 8).

2. The electronic module according to claim 1, **characterised in that** the first or the second indexing elements are holes, while respectively the second or the first indexing elements are projecting elements that can engage with the holes.

3. The electronic module according to claim 1 or 2, **characterised in that** the second cover (8) has a shape more or less corresponding to the shape of the first cover (6), with a central part (30) and at least one support that is in contact with the second face of the electronic card (4).

4. The electronic module according to one of claims 1 to 3, **characterised in that** at least one thermal contact point is implemented between one cover (6, 8) and one of the electronic components (14) of the electronic card (4).

5. The electronic module according to claim 4, **characterised in that** a thermal interface is disposed between one of the electronic components (10) and at least one cover (6, 8).

6. An electronic assembly, comprising at least one electronic module according to one of claims 1 to 5, made up of an electronic card (4), a first cover (6) and a second cover (8), and a connection box (40) in which slider zones (38) are disposed in order to allow installation of at least one electronic module (2) in the said box (40), **characterised in that** the first cover (6) includes at least one support (26) onto which the electronic card (4) is added, the said at least one support (26) of the first cover (6) being in contact with a wall (44) of the corresponding slider zone, when the electronic module (2) is installed in the connection box (40), at least one of the covers (6, 8) including first indexing elements (34), the electronic card (4) including second complementary indexing elements (36) that can engage with the first indexing elements (34) during positioning of the electronic card (4) between the covers (6, 8).

7. The electronic assembly according to claim 6, **characterised in that** the first or the second indexing elements are holes, while respectively the second or the first indexing elements are projecting elements that can engage with the holes.

8. The electronic assembly according to claim 6 or 7, **characterised in that** the electronic card (4) has a first face (16) on which electronic components (10) are disposed, a first face (46) of the said at least one support (26) of the first cover (6) being in contact, on the one hand, with the wall (44) of the corresponding slider zone and, on the other hand, with the first face (16) of the electronic card (4).

9. The electronic assembly according to one of claims 6 to 8, **characterised in that** an expansion element (42) is disposed in the slider zones (38), so that the activation of the expansion element (42) can press at least one support (26) of the first cover (6) against the wall (44) of the corresponding slider zone (38).

10. The electronic assembly according to claim 9, **characterised in that** the electronic card (4) and the two covers (6, 8) extend substantially over the same height, so that the assembly formed by the card (4) and the covers (6, 8) is disposed in the slider zones (38), the first cover (6) being in contact with the wall (44) of the slider zones (38), the card (4) and the second cover (8) being pressed against the first cover (6) under the action of the expansion element (42).

11. An aircraft **characterised in that** it comprises at least one electronic module according to one of claims 1 to 5 or at least one electronic assembly according to one of claims 6 to 10.
